Europäisches Patentamt

European Patent Office

Office européen des brevets

(19)

(11) Numéro de publication: **0 022 388**
**B1**

(12) **FASCICULE DE BREVET EUROPEEN**

(45) Date de publication du fascicule du brevet: **28.09.83**

(21) Numéro de dépôt: **80400865.4**

(22) Date de dépôt: **13.06.80**

(51) Int. Cl.³: **H 01 L 29/78,**
**H 01 L 29/60,**
**H 01 L 21/225**

(54) Procédé de fabrication d'un transistor à effet de champ du type DMOS à fonctionnement vertical.

(30) Priorité: **10.07.79 FR 7917848**

(43) Date de publication de la demande:
**14.01.81 Bulletin 81/2**

(45) Mention de la délivrance du brevet:
**28.09.83 Bulletin 83/39**

(84) Etats contractants désignés:
**CH DE GB IT LI NL SE**

(56) Documents cités:
**FR - A - 2 140 007**
**FR - A - 2 325 192**
**US - A - 3 967 981**

(73) Titulaire: THOMSON-CSF
173, Boulevard Haussmann
F-75379 Paris Cedex 08 (FR)

(72) Inventeur: Tonnel, Eugène
"THOMSON-CSF" SCPI 173, bld Haussmann
F-75360 Paris Cedex 08 (FR)

(74) Mandataire: de Beaumont, Michel et al,
THOMSON-CSF SCPI 173, Bld Haussmann
F-75379 Paris Cedex 08 (FR)

Courier Press, Leamington Spa, England.

## Procédé de fabrication d'un transistor à effet de champ du type DMOS à fonctionnnement vertical

La présente invention concerne dans le domaine des dispositifs à semiconducteurs les transistors à effet de champ du type "double diffusé MOS" connus sous le nom de "DMOS à fonctionnnement vertical" et destinés à être utilisés pour l'amplification de puissance ou la commutation et plus particulièrement un procédé de fabrication de ce type de transistors.

Les transistors à effet de champ ont à ce jour été utilisés principalement comme micro-composants dans les circuits intégrés. La structure de tels circuits était principalement constituée d'éléments symétriques isolés les uns des autres et de performances électriques adaptées au compromis rapidité consommation recherché en général.

Cependant les caractéristiques propres des transistors à effet de champ, temps de coupure faible, linéarité, grande stabilité thermique, permettent d'envisager un champ d'application accru de ces transistors réservé jusqu'à ce jour aux transistors bipolaires notamment dans le domaine de l'amplification, de la commutation rapide et de la commutation ou commande de puissance.

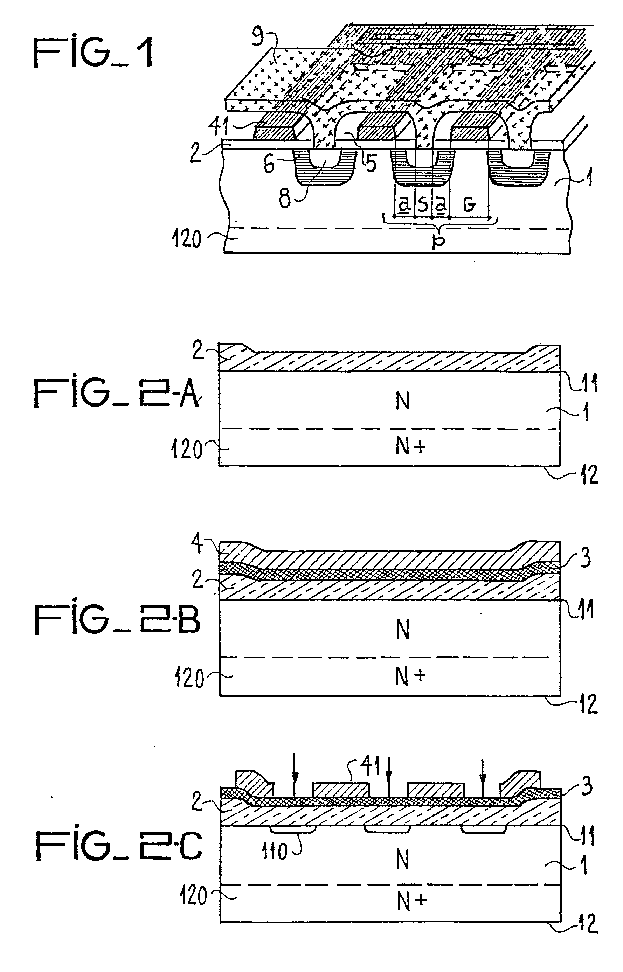

Les transistors DMOS à fonctionnement vertical tels que représentés en coupe figure 1 comportent sur une plaquette de matériau semiconducteur 1, tel que du silicium, une structure formée de doigts parallèles 41 formant la grille du transistor, la grille étant isolée de la plaquette de matériau semiconducteur par une couche d'oxyde de silicium 2. Les doigts parallèles 41 sont constitués par du silicium polycristallin. La plaquette de matériau semiconducteur 1 comporte, entre les doigts formant la grille, des zones imbriquées 6 et 8 formant respectivement les zones de formation de canal et régions de sources du transistor. A titre d'exemple, la plaquette de silicium a un type de conductivité N, les zones de formation de canal 6 sont diffusées de type P et les régions de source 8 sont dopées N⁺. La plaquette de silicium comporte également une région de drain 120 de type de conductivité N⁺ et une métallisation 9 isolée des doigts de grille 41 par une couche d'oxyde de silicium 5 développée par croissance thermique à partir du silicium polycristallin formant des doigts de grille 41. La métallisation 9 forme la connexion des régions de source.

Ainsi que représenté figure 1, la structure, relativement à ce type de transistor, se développe sous forme de doigts perpendiculaires au plan de cette coupe. Pour une dimension donnée de ces doigts selon une direction perpendiculaire au plan de cette coupe, la conductance par unité de surface de tels dispositifs est inversement proportionnelle au pas p du réseau de doigts imbriqués. Ce pas s'écrit p=G+S+2a où G est la dimension latérale de chaque doigt, S la dimension latérale du contact de source et *a* la tolérance de positionnement du contact de source par rapport à l'électrode de grille. Dans les transistors de ce type, la conductance par unité de surface est proportionnelle à la dimension latérale de la zone de formation de canal constituée par les diffusions. Pour une structure imbriquée, la dimension latérale de la zone de formation de canal croît lorsque le pas p de la structure décroît, la conductance par unité de surface étant, dans ce cas, limitée notamment par l'existence de la tolérance de positionnement *a* du contact par rapport à la grille.

Un transistor de ce type (mais à fonctionnement latéral) obtenu par un autre procédé ne permettant pas un autoalignement des connexions de source est décrit dans la demande de brevet français 2 325 192.

Un objet de la présente invention est de prévoir un procédé de fabrication d'un transistor à effet de champ dont le tolérances de positionnement du contact de source sont sensiblement supprimées.

Un autre objet de la présente invention est de prévoir un procédé de fabrication d'un transistor à effet de champ permettant un contrôle amélioré des dopages de la région de source.

Un autre objet de la présente invention est de prévoir un procédé de fabrication d'un transistor du type DMOS à fonctionnement vertical particulièrement adapté à la commutation de puissance.

Le procédé selon l'invention consiste, à partir d'une plaquette de silicium d'un premier type de conductivité comprenant une première face principale et une deuxième face opposée à cette première face, la zone de la plaquette située au voisinage de la deuxième face présentant une conductivité de même type et supérieure à la conductivité de la plaquette constituant le drain du transistor, à effectuer les étapes de traitement ci-après:

— formation par croissance thermique d'une première couche d'oxyde de silicium d'épaisseur déterminée sur la première face du substrat,
— formation sur cette première couche d'oxyde de silicium d'une couche de nitrure de silicium,
— dépôt sur cette couche de nitrure de silicium d'une couche de silicium polycristallin dopé et ouverture de cette couche par masquage et attaque chimique pour former les électrodes de grille du transistor,
— formation par implantation ionique, au moyen du masque formé par les électrodes de grille, d'un dopant de type de conductivité opposé à celui de la plaquette,
— chauffage pour développer, à partir du silicium polycristallin constituant les électrodes de grille, une deuxième couche d'oxyde de silicium d'épaisseur plus grande que celle de la première couche et pour faire diffuser le dopant et constituer dans la plaquette de silicium des zones de type de conductivité opposé à celui de la plaquette,
— attaque sélective de la couche de nitrure de silicium et attaque de l'oxyde de silicium sur une épaisseur correspondant à celle de la première couche pour mettre à nu la plaquette,
— dépôt d'une deuxième couche de silicium polycristallin dopé selon le même type de conductivité que celui de la zone de la plaquette constituant le drain du transistor,
— chauffage pour faire diffuser le dopant de la deuxième couche de silicium polycristallin dans les portions sous-jacentes de la plaquette pour constituer les zones de source du transistor,
— ouverture de la deuxième couche de silicium polycristallin par masquage pour les connexions de grille et de canal du transistor.

La mise en oeuvre du procédé selon l'invention permet d'obtenir un transistor à effet de champ à grille isolée du type DMOS à fonctionnement vertical de puissance dans lequel l'électrode de grille est séparée de la première face principale de la plaquette de silicium par une couche d'oxyde de silicium et par une couche de nitrure de silicium superposées, l'électrode de grille étant disposée directement sur la couche de nitrure de silicium, la connexion reliant électriquement chaque région de source étant constituée par l'intermédiaire d'une couche de silicium polycristallin dopé de même type de conductivité que les régions de source du transistor.

Ce transistor à effet de champ peut être utilisé pour la commutation ou l'amplification de puissance, la conductance par unité de surface étant accrue de l'ordre de 40% par rapport aux structures antérieures.

L'invention sera mieux comprise à l'aide de la description et des dessins ci-après où les mêmes références représentent les mêmes éléments et dans lesquels outre la figure 1 représentant un schéma relatif à une structure de transistor DMOS de l'art antérieur,

— la figure 2, représent en 2a, 2b, 2c, 2d, 2e et 2f des vues en coupe de la plaquette de silicium après différentes étapes du procédé selon l'invention;
— les figures 3a, 3b, 3c représentent respectivement un mode de réalisation particulier du transistor à effet de champ selon l'invention dans lequel à titre d'exemple, ont été représentées trois régions de source;
— les figures 3b, 3c représentent respectivement une coupe transversale selon C D et une coupe longitudinale selon A B du mode de réalisation représenté figure 3.

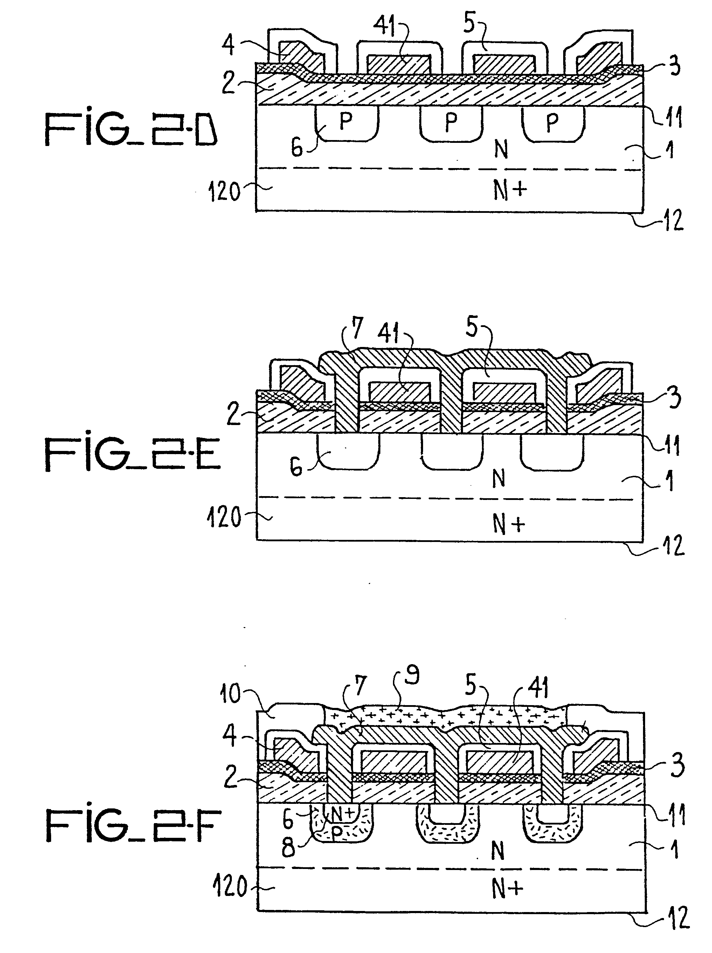

La figure 2 représente, suivant les principales étapes référencés a à f, le procédé de fabrication d'un transistor DMOS à fonctionnement vertical selon l'invention. Le procédé de fabrication sera décrit conformément à la figure 2 à partir d'un plaquette de silicium 1 d'un premier type de conductivité de type N par exemple. Tout autre mode de mise en oeuvre du procédé selon l'invention à partir d'une plaquette de silicium de conductivité de type P ne sort pas du cadre de la présente invention. La plaquette de silicium 1 comporte une première face principale 11 et une deuxième face opposée à cette première face 12. La zone située au voisinage de la deuxième face présente une conductivité de même type et supérieure à la conductivité de la plaquette et constitue le drain du transistor. Selon la figure 2, la zone 120 située au voisinage de la deuxième face est de type $N^+$. Le procédé selon l'invention comporte les étapes suivantes:

A l'étape a figure 2, une première couche d'oxyde de silicium 2 est formée par croissance thermique. Cette couche d'oxyde de silicium est formée sur la première face 11 de la plaquette selon deux épaisseurs différentes, l'une forte, de l'ordre de $1\mu$ à la périphérie de la plaquette l'autre faible, de l'ordre de $0,1\mu$, dans la région active de l'élément.

A l'étape b, est formée sur la première couche d'oxyde de silicium 2 une couche de nitrure de silicium 3. La couche de nitrure de silicium 3 est elle-même recourverte, par dépôt sur cette couche, d'une couche de silicium polycristallin dopé 4. Les épaisseurs relatives des couches d'oxyde de silicium et de nitrure de silicium sont choisies de façon à minimiser les contraintes mécaniques et les variations de la tension de seuil du transistor pouvant résulter d'un blocage de la grille. A titre d'exemple, pour une épaisseur d'oxyde de silicium de 100 nanomètres, une couche de nitrure de silicium de 50 nanomètres est suffisante. L'épaisseur de la couche de silicium polycristallin 4 est choisie de façon à assurer la croissance d'oxyde thermique permettant d'isoler ultérieurement les électrodes de grille et de manière à présenter une résistance par unité de surface assez faible pour ne pass réduire le temps de commutation du transistor. La couche de silicium polycristallin 4 est ensuite ouverte par masquage et par attaque chimique en vue de former les électrodes de grille du transistor.

A l'étape c, la couche de silicium polycristallin 4 a été représentée ouverte après attaque chimique, les électrodes de grille étant référencées 41. A l'étape c, sont formées des zones d'implantation 110 par implantation ionique d'un dopant de type de conductivité opposé à celui de la plaquette au moyen du masque formé par les électrodes de grille 41. A titre d'exemple, conformément à la figure 2, le dopant implanté est du bore. L'implantation est effectuée avec une énergie suffisante pour traverser les couches d'oxyde de silicium 2 et de nitrure de silicium 3.

A l'étape d, a été développée par chauffage à partir du silicium polycristallin constituant les électrodes de grille une deuxième couche d'oxyde de silicium 5 d'épaisseur plus grande que celle de la première couche 2. Simultanément, le dopant implanté dans les zones d'implantation 110 constitue dans la plaquette de silicium par diffusion des zones de type de conductivité opposé à celui de la plaquette. Ces zones sont référencées 6 après l'étape d et sont des zones de conductivité du type P selon l'exemple de la figure 2. La deuxième couche d'oxyde de silicium 5 a pris naissance à la surface des électrodes de grille 41 alors que l'oxydation de la plaquette et la croissance de la première couche d'oxyde de silicium 2 étaient interdites par la barrière de nitrure de silicium 3.

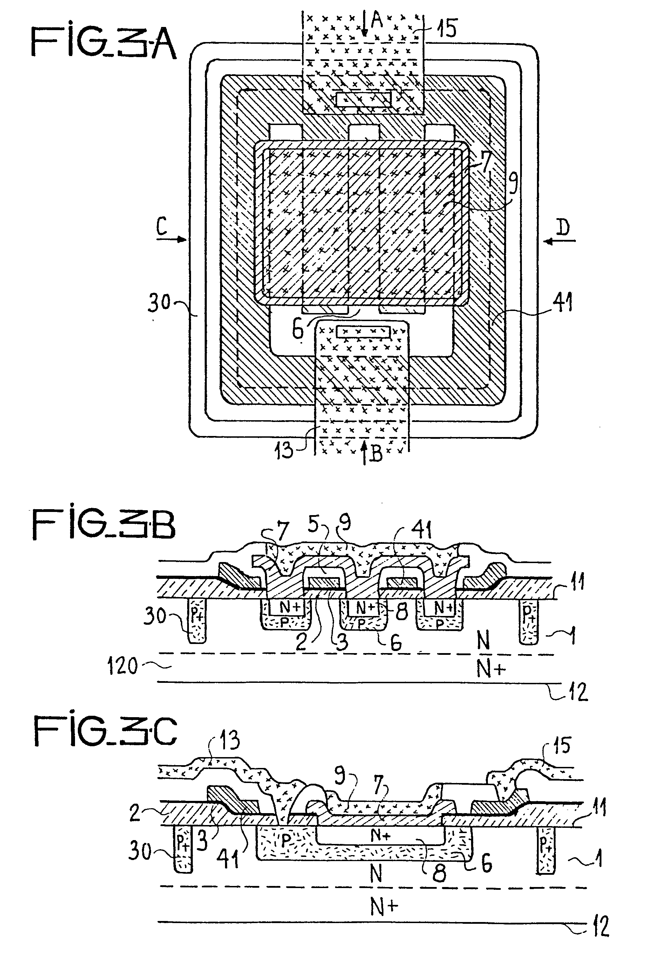

A l'étape e, la couche de nitrure de silicium 3 puis la couche d'oxyde de silicium ont été attaquées successivement de manière sélective et sans étape de masquage supplémentaire, de manière à mettre à nu la plaquette entre les électrodes de grille. Une fois la couche de nitrure attaquée, on procède à l'attaque de la couche d'oxyde de silicium 2 en utilisant la couche de nitrure de silicium 3 comme masque. Durant cette attaque, les régions oxydées 5 des électrodes de grille non protégées par le nitrure de silicium seront également attaquées. Il est cependant possible de limiter le temps d'attaque de la couche d'oxyde de silicium 2 à éliminer au minimum nécessaire et d'assurer un compromis entre épaisseur relative de la première couche d'oxyde de silicium 2 à éliminer et fraction de la couche d'oxyde de silicium polycristallin 5 à conserver. L'attaque successive de la première couche d'oxyde de silicium et de la couche de nitrure de silicium est suivie d'un dépôt d'une deuxième couche de silicium polycristallin dopé 7 de même type de conductivité que celui de la zone de la plaquette constituant le drain du transistor. Selon l'exemple de réalisation non limitatif de la figure 2, la deuxième couche de silicium polycristallin est dopée N+. Au cours de cette étape, dans les parties de la plaquette qui ne portent pas de grille, on effectuera une réservation par un masque de résine pour établir une prise de contact localisée avec la zone de formation de canal. Ceci n'est pas visible en figure 2e mais apparaîtra notamment en relation avec les figures 3b et 3c. A l'étape f, un chauffage a permis de faire diffuser le dopant de la deuxième couche de silicium polycristallin 7 dans les portions sous-jacentes de la plaquette pour constituer les zones de source 8 du transistor. Les zones de formation de canal du transistor sont délimitées d'une part par la zone de diffusion des zones d'implantation et d'autre part par la zone de diffusion du dopant de la deuxième couche de silicium polycristallin 7. Une étape d'ouverture de la deuxième couche de silicium polycristallin permet par un masquage bmnt la tolérance de positionnement n'est pas critique d'effectuer les connexions de grille et de canal du transistor. La première couche de silicium polycristallin 4 peut sans inconvénient être dopée N+ ou P+, la nature du dopant N ou P intervenant uniquement compte tenu de la différence des niveaux de Fermi correspondants pour la valeur de la tension de grille appliquée au transistor pour assurer le fonctionnement de celui-ci. La première couche de silicium polycristallin 4 peut être dopée soit durant le dépôt, soit après dépôt, ce dépôt pouvant être effectué à basse pression par décomposition de silane à température voisine de 600 degrés. Selon un mode de réalisation particulier du procédé objet de l'invention, l'étape d'ouverture de la deuxième couche de silicium polycristallin 7 est précédée d'un dépôt d'une troisième couche d'oxyde de silicium 10 dopé selon un même type de conductivité que celiu de cette deuxième couche de silicium polycristallin. Selon l'exemple de la figure 2, la troisième couche d'oxyde de silicium est dopée avec du phosphore. Cette couche est ensuite fluée à température élevée avant ouverture des contacts au droit des régions de source, de formation de canal et de grille. Un fluage à température élevée de la troisième couche d'oxyde de silicium permet d'araser les arêtes vives des ouverture de contact au droit des régions de source de canal et de grille. Ces régions sont ensuite connectées par le biais de métallisations 9. Le procédé selon l'invention permet d'obtenir des transistors à effet de champ de conductance par unité de surface très améliorée du fait de l'utilisation à deux reprises de procédés d'auto-alignement des contacts permettant de supprimer les tolérances de positionnement les plus critiques. En effet, un premier auto-alignement des électrodes de grille par rapport à la zone de formation de canal est obtenu du fait de l'utilisation de électrodes de grille comme masque d'implantation. Un deuxième auto-alignement des contacts et de la région de source du transistor par rapport à l'électrode de grille permet notamment de supprimer la tolérance de positionnement des contacts de source par rapport à cette grille, à l'épaisseur d'oxyde de silicium près isolant les électrodes de grille, du fait de la constitution des zones de source par diffusion à partir de la deuxième couche de silicium polycristallin, les électrodes de grille étant à nouveau utilisées comme masque. Le procédé utilisé permet d'obtenir la plus forte dimension latérale de canal par unité de surface possible. Dans le cas d'une structure à sources et grilles imbriquées, des pas de 10 microns sont réalisables avec des techniques de photogravure optique classiques. Dans le cas de réalisation de transistors de grande puissance, une disposition en double couche des électrodes de source et de grille permet une interconnexion aisée entre les différentes électrodes. Pour des éléments travaillant sous faible tension, il est encore possible de réduire le pas en réduisant la largeur de grille. On peut ainsi obtenir avec des procédés de photogravure plus adaptés des pas de l'ordre de 5 microns. Une telle technique permet un gain en conductance par unité de surface d'un facteur 5 par rapport aux éléments actuels et est susceptible d'autoriser des performances supérieures à celles des éléments bipolaires.

La figure 3a représente suivant une vue de dessus un transistor à effet de champ à grille isolée obtenu selon l'invention. Les figures 3b, 3c représentent respectivement une coupe transversale selon C D de la figure 3a et une coupe longitudinale selon A B de cette même figure. Le mode de réalisation d'un transistor à effet de champ selon l'invention représenté figures 3a à 3c, est donné à titre d'exemple, l'exemple concernant une structure du type imbriqué ne comportant que trois doigts pour raison de simplicité. Dans cet example le transistor sera décrit dans le cas où la plaquette de silicium est une plaquette de silicium dopé de type N. Tout mode de réalisation dans lequel la plaquette de silicium est une plaquette de silicium dopé de type P par exemple ne sort pas du cadre de la présente invention.

Le transistor à effet de champ obtenu selon l'invention comporte, dans une plaquette de silicium 1 d'un premier type de conductivité comprenant une première face 11 et une deuxième face opposée 12, une région de drain 120 située au voisinage de la deuxième face et de conductivité supérieure et du même type que la conductivité de la plaquette. Le transistor comporte au moins deux zones imbriquées affleurant à la surface de la première face 11 et comportant chacune un première et une deuxième zone de conductivité respectivement de même type et de type opposé au type de conductivité de la plaquette. Sur les figures 3a, 3b, 3c, les première et deuxième zones de même type de conductivité et de type de conductivité opposé à celui de la plaquette sont référencées respectivement 8 et 6. La deuxième zone 6 sépare la première zone 8 de la région de drain 120 pour chaque zone imbriquée. Chaque première zone 8 constitue une région de source du transistor. La première face de la plaquette 11 comporte, disposée entre chaque région de source de transistor, une électrode de grille de silicium polycristallin dopé 41 recouverte d'une couche d'oxyde de silicium 5. L'électrode de grille 41 est séparée de la première face de la plaquette de silicium 11 par une couche d'oxyde de silicium 2 et par une couche de nitrure de silicium 3 superposées. L'électrode de grille est disposée directement sur la couche de nitrure de silicium. La connexion 9 reliant électriquement chaque région de source est constituée par l'intermédiaire d'une couche de silicium polycristallin dopé 7 de même type de conductivité que les régions de source du transistor. Selon le mode de réalisation des figures 3a à 3c on distingue sur ces figures un anneau de garde 30 de type $P^+$, non connecté conformément au mode de réalisation des figures 3a à 3c et représenté par un seul anneau. Cet anneau de garde peut en fait être constitué d'une série d'anneaux concentriques dans le cas de dispositifs fonctionnant à tension très élevée. La grille du transistor 41 forme un cadre dans lequel la zone de formation de canal est diffusée de type P dans la plaquette de silicium. Les régions de source 8 dopées $N^+$ selon le mode de réalisation des figures 3a à 3c forment des doigts latéralement alignés sur le bord la grille 41. Les régions de source 8 sont réunies par une deuxième couche de silicium polycristallin 7 à partir de laquelle les régions de sources ont été formées par diffusion. La deuxième couche de silicium polycristallin 7 est isolée de la grille 41 par une couche d'oxyde de silicium 5 obtenue par oxydation du silicium polycristallin constituant cette grille. La couche de silicium polycristallin 7 ne recouvre pas la partie de la zone de formation de canal qui sera utilisée pour la prise de contact de la région de canal. Les connexions 13 du canal et 9 de la source sont représentées isolées mais peuvent être réunies, notamment lorsque le transistor est utilisé comme composant discret. L grille 41 est connectée par la connexion 15, soit vers une sortie, soit vers une diode de protection qui peut être diffusée sur la même plaquette de silicium. Cette diode, non représentée peut être réalisée avec la diode source-canal du transistor et localisée par exemple à la périphérie de la plaquette de silicium. La structure du transistor représentée figure 3a, ne comporte que trois doigts de sources, l'obtention de transistors à conductance élevée pouvant, sans sortir du cadre de la présente invention, être obtenue par disposition en parallèle de plusieurs sources à l'intérieur d'un même cadre de grille. Le nombre de sources en parallèle ainsi que la longueur des doigts sont déterminés par la résistance limite admise pour le canal et la grille du dispositif. Dans le cas de la mise en oeuvre de transistors à effet de champ du type intégré, conformément au procédé selon l'invention, le contact de drain est pris sur la face avant ou première face de la plaquette par le biais d'une diffusion profonde et d'une couche enterrée conformément à la technique des circuits intégrés bipolaires. Dans le cas d'une réalisation conformément aux figures 3a à 3c, la diffusion profonde et la couche enterrée sont de type $N^+$. De même chaque région de source de conductivité du type $N^+$ est par exemple dopée à l'arsenic ou au phosphore. Dans les transistors à effet de champ selon l'invention, le contact sur les régions de source est établi par l'intermédiaire de la deuxième couche de silicium polycristallin. La présence de silicium polycristallin entre les régions de source et les métallisation de contact permet d'éviter la migration du silicium de la source dans les métallisations de contact et assure une meilleure tenue du contact en fonctionnement à forte puissance. Le transistor à effet de champ ainsi décrit peut être protégé par une couche de passivation et complété par des bossages métalliques permettant d'assurer les connexions à des circuits extérieurs.

## Revendications

1. Procédé de fabrication d'un transistor à effet de champ du type DMOS à fonctionnement vertical et à structure de grille digitée, à partir d'une plaquette de silicium (1) de premier type de conductivité comprenant une première face principale (11), et une deuxième face (12) opposée à cette première face, la zone (120) de la plaquette située au voisinage de la deuxième face présentant une conductivité de même type et supérieure à la conductivité de la plaquette et constituant le drain du transistor, comportant les étapes suivantes:

— formation par croissance thermique d'une première couche d'oxyde de silicium (2) d'épaisseur déterminée sur la première face de la plaquette,
— formation sur la première couche d'oxyde de silicium d'une couche de nitrure de silicium (3),
— dépôt, sur la couche de nitrure de silicium, d'une couche de silicium polycristallin dopé (4) et ouverture de cette couche par masquage et attaque chimique pour former les électrodes de grille (41) du transistor,
— formation de zones d'implantation (110) par implantation ionique d'un dopant de type de conductivité opposé à celui de la plaquette au moyen du masque formé par les électrodes de grille,

caractérisé en ce qu'il comprend en outre les étapes suivantes:

— chauffage pour développer, à partir du silicium polycristallin (41) constituant les électrodes de grille, une deuxième couche d'oxyde de silicium (5) d'épaisseur plus grande que celle de la première couche et pour faire diffuser le dopant implanté et constituer dans la plaquette de silicium, des zones (6) de type de conductivité, opposé à celui de la plaquette,
— attaque sélective de la couche de nitrure de silicium (3) et attaque de l'oxyde de silicium sur une épaisseur correspondant à celle de la première couche d'oxyde de silicium pour mettre à nu la plaquette,
— dépôt d'une deuxième couche de silicium polycristallin (7) dopé de même type de conductivité que celui de la zone de la plaquette constituant le drain du transistor,
— chauffage pour faire diffuser le dopant de la deuxième couche de silicium polycristallin dans les portions sous-jacentes de la plaquette pour constituer les zones de source (6) du transistor.

2. Procédé selon la revendication 1, caractérisé en ce que la plaquette de silicium est de conductivité de type N, la zone de la plaquette située au voisinage de la deuxième face constituant le drain du transistor présentant une conductivité de type N$^+$, le dopant implanté constituant des zones de conductivité de type P, la deuxième couche de silicium polycristallin étant dopée N$^+$.

3. Procédé selon la revendication 2, caractérisé en ce que la première couche de silicium polycristallin est dopée N$^+$.

4. Procédé selon la revendication 2, caractérisé en ce que la première couche de silicium polycristallin est dopée P.

5. Procédé selon la revendication 2, caractérisé en ce que la deuxième couche de silicium polycristallin est dopée à l'arsenic.

## Patentansprüche

1. Verfahren zur Herstellung eines FET vom Typ DMOS mit vertikaler Betriebsweise und mit fingerförmiger Gitterstrucktur, ausgehend von einem Siliziumplättchen (1) eines ersten Leitfähigkeitstyps, das eine erste Hauptoberfläche (11) und dergegenüber eine zweite Oberfläche (12) aufweist, wobei die Zone (120) des Plättchens, die in der Nähe der zweiten Oberfläche liegt, eine Leitfähigkeit desselben Typs, aber größeren Werts als die Leitfähigkeit des Plättchens besitzt und den Drainanschluß des Transistors bildet, und wobei das Verfahren folgende Schritte aufweist:

— Ausbildung einer ersten Siliziumoxidschicht (2) einer bestimmten Dicke auf der Oberfläche des Plättchens durch thermisches Wachsen,
— Ausbildung einer Schicht Siliziumnitrid (3) auf der ersten Siliziumoxidschicht,
— Niederschlag einer Schicht (4) dotierten polykristallinen Siliziums aus der Siliziumnitridschicht und Öffnung dieser Schicht durch Maskierung und chemisches Wegätzen, wodurch die Elektroden des Gitters (41) des Transistors gebildet werden,
— Ausbildung von Implantationszonen (110) durch Ionenimplantation eines Dotierstoffes von einem Leitfähigkeitstyp, der dem des Plättchens entgegengesetzt ist, mithilfe der von den Gitterelektroden gebildeten Maske,

dadurch gekennzeichnet, daß es außerdem folgend Schritte aufweist:

— Erhitzung, um ausgehend vom polykristallinen Silizium (41), das die Gitterelektroden bildet, eine zweite Siliziumoxidschicht zu entwickeln, deren Dicke größer als die der ersten Schicht ist, um den implantierten Dotierstoff diffundieren zu lassen und in dem Saliziumplättchen Zonen (6) eines Leitfähigkeitstyps zu bilden, der dem des Plättchens entgegengesetzt ist,

— selektives Wegätzen der Siliziumnitridschicht (3) und Ätzen des Siliziumoxids auf eine Tiefe entsprechend der der ersten Siliziumoxidschicht, wodurch das Plättchen freigelegt wird,

— Niederschlag einer zweiten Schicht (7) polykristallinen Siliziums, das gemäß demselben Leitfähigkeitstyp wie die den Drain des Transistors bildende Zone des Plättchens dotiert ist,

— Erhitzung, um den Dotierstoff der zweiten Schicht polykristallinen Siliziums in die darunterliegenden Bereiche des Plättchens diffundieren zu lassen, wodurch die Source-Zonen (6) des Transistors gebildet werden.

2. Verfahren nach Anspruch 1, dadurch gekennzeichnet, daß das Siliziumplättchen vom Leitfähigkeitstyp N, die in der Nähe der zweiten Oberfläche liegende Zone des Plättchens, die den Drainanschluß des Transistors bildet, vom Typ N$^+$ und der implantierte die Zonen bildende Dotierstoff vom Typ P ist, während die zweite Schicht aus polykristallinem Silizium mit einem Dotierstoff des Typs N$^+$ dotiert ist.

3. Verfahren nach Anspruch 2, dadurch gekennzeichnet, daß die erste Schicht polykristallinen Siliziums gemäß dem Typ N$^+$ dotiert ist.

4. Verfahren nach Anspruch 2, dadurch gekennzeichnet, daß die erste Schicht polykristallinen Siliziums gemäß dem Typ P dotiert ist.

5. Verfahren nach Anspruch 2, dadurch gekennzeichnet, daß die zweite Schicht polykristallinen Siliziums mit Arsen dotiert ist.

## Claims

1. A method of manufacturing a DMOS type FET which functions vertically and which shows a finger-shaped grid structure, starting from a silicium plate (1) of a first type of conductivity having a first, main face (11) and opposed thereto a second face (12), the zone (120) of the plate in the vicinity of the second face presenting a conductivity of the same type but of a higher degree than the plate and constituting the drain of the transistor, this method including the following steps:

— building up of a first layer of silicium oxide (2) of a given thickness on the first face of the plate by thermal growth,

— building up of a layer of silicium nitride (3) on the first layer of silicium oxide,

— depositing of a layer of doped polycristalline silicium (4) on the layer of silicium nitride and opening of this layer

by masking and by chemical attack in order to obtain the grid electrodes (41) of the transistor,

— building up of implantation zones (110) by ionic implantation of a doping material of opposed conducitivity type with respect to that of the plate, by means of the mask formed by the grid electrodes,

characterized in that it further comprises the following steps:

— heating up in order to develop, out of the polycristalline silicium (41) constituting the grid electrodes, a second layer of silicium oxide (5) the thickness of which is greater than that of the first layer, and to let the implanted doping material diffuse and to constitute, in the silicium plate, zones (6) of opposed conductivity type with respect to the plate,

— selective attack of the silicium nitride layer (3) and attack of the silicium oxide up to a thickness corresponding to the thickness of the first silicium oxide layer in order to uncover the plate,

— depositing of a second layer of polycristalline silicium (7) which is doped according to the same conductivity type as the zone of the plate which constitutes the drain of the transistor,

— heating up in order to let the doping material of the second layer of polycristalline silicium diffuse into the underlying portions of the plate in order to constitute the source zones (6) of the transistor.

2. A method according to claim 1, characterized in that the silicium plate is of the conductivity type N, the zone of the plate in the vicinity of the second face constituting the drain of the transistor is of the conductivity type N$^+$, the implanted doping material constituting the zones is of the conductivity type P and the second layer of polycristalline silicium is doped N$^+$.

3. A method according to claim 2, characterized in that the first layer of polycrystalline silicium is doped N$^+$.

4. A method according to claim 2, characterized in that the first layer of polycrystalline silicium is doped P.

5. A method according to claim 2, characterized in that the second layer of polycristalline silicium is doped with arsenic.

FIG_1

FIG_2-A

FIG_2-B

FIG_2-C

FIG_2·D

FIG_2·E

FIG_2·F

FIG.3A

FIG.3B

FIG.3C